(19) Europäisches Patentamt
European Patent Office
Office européen des brevets

(11) Publication number: **0 034 490**
**B1**

(12) **EUROPEAN PATENT SPECIFICATION**

(45) Date of publication of patent specification: **02.10.85**

(21) Application number: **81300617.8**

(22) Date of filing: **13.02.81**

(51) Int. Cl.$^4$: **G 03 F 7/10,** G 03 F 7/26, G 03 C 1/00, G 03 C 1/72, G 03 C 1/94, G 03 C 5/24

(54) **Photographic system and photographic material for use therein.**

(30) Priority: **15.02.80 BG 46640/80**

(43) Date of publication of application: **26.08.81 Bulletin 81/34**

(45) Publication of the grant of the patent: **02.10.85 Bulletin 85/40**

(84) Designated Contracting States: **BE CH DE FR GB LI NL**

(56) References cited: **US-A-3 762 325**

(73) Proprietor: **Zlafop-Ban**
**Quartal Geo Milev Block V-2**
**Sofia (BG)**

(72) Inventor: **Konstantinov, Ivan Teofilov**
**13, St.Peshev Street**
**Sofia (BG)**
Inventor: **Mednikarov, Borislav Dimitrov**
**65, Vitosha Street**
**Sofia (BG)**
Inventor: **Sahatchiev, Maria Andreeva**
**27, San-Stefano Street**
**Sofia (BG)**
Inventor: **Burov, Atanas Tzvetanov**
**53, L.Karavelov Street**
**Sofia (BG)**

(74) Representative: **Silverman, Warren et al**
**HASELTINE LAKE & CO. Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 034 490 B1

**Description**

This invention relates to a photographic system for use in photolithography, for use for example in the production of microelectronic circuits and the production of sensitizing and printing elements in offset printing formes and to photographic materials for use therein.

As used herein, a photographic system denotes a combination of materials to be used together, namely a combination of a photographic material comprising a photosensitive layer of the type to be described herein and an alkaline developing agent to be used on the photosensitive layer after exposure thereof to radiation, to obtain a visible photographic image.

It is known that some inorganic photosensitive substances, such as arsenous sulphide undergo changes in some of their physical and chemical properties after exposure to radiation of various types. If only partial or imagewise exposure to radiation of such substances takes place, it has been found that the change in chemical properties on irradiation includes an increase in the rate of dissolution in certain solvents in those areas of the photosensitive substance which have been irradiated as compared to the non-irradiated areas. The solvents generally employed are alkaline solutions. These inorganic photosensitive substances are nevertheless stable to some chemical reagents, for example acids, thereby enabling acid to be employed to etch out metal exposed on dissolution of exposed photosensitive substance leaving a metal image corresponding to the subject originally photographed on removal of the residual undissolved photosensitive layer. Such a procedure for use of the photographic material of the aforementioned type in the production of photoresist materials, for example for use in the production of microelectronic printed circuits is described by Nogai . H, Yoshikawa . A, Toyoshima . Y, Ochi . O and Mizushima . Y in Applied Physics Letters *28,* 145 (1976) and in Applied Physics Letters *29,* 677 (1976). The capacity for inking of the materials resulting from dissolution of imagewise exposed photosensitive material renders them suitable, in principle, for use in the production of offset printing formes (U.S. Patent No. 3,762,325). Notwithstanding the advantages given in the first two aformentioned references of such a photographic system for use in the production of photoresist material, as compared to the previously widely used photolacquers, namely exceptionally high resolution, the possibility of depositing the photosensitive layer on a substrate by evaporation in a vacuum, thereby achieving excellent uniformity and impurity-free preparation conditions, very good adhesion, thereby allowing the more intricate processes of etching of the substrate or an intermediate layer to be carried out successfully, nevertheless such photographic materials have not hitherto found practical application. The main reason for this is the low ratio between the rates of disssolution of imagewise exposed and unexposed photosensitive substance in the presence of the usual alkaline solutions employed for such purpose. This ratio may be termed photoselectivity of dissolution. This ratio increases on increasing the extent of exposure, but even when exposure is at the maximum practical, the alkaline development procedure does not provide sufficient photoselectivity of dissolution. Moreover, the photographic material is generally insufficiently sensitive to the comparatively high exposure required to achieve the maximum photoselectivity of dissolution.

Hence the following two disadvantages of the aforementioned type of photographic system may be identified:

1. Low sensitivity in comparsion to organic photolacquers hitherto used.
2. Very poor tolerance during the duration of the alkaline development, i.e. development to the critical extent is difficult to achieve.

The critical character of the alkaline development results from the low photoselectivity of dissolution which results, on complete removal of exposed inorganic photosensitive substance, in unexposed areas being affected to some extent depending upon the amount of exposure and on the activity of the alkaline developer as a solvent for the photosensitive substance, the pH of the developer being of particular importance here. Because of the way in which the two aforementioned disadvantages are inter-related, there has not hitherto been described any photographic system which simultaneously solves both problems.

Experiments carried out by the inventors have revealed two further disadvantages in such photographic systems. The first is the appearance of pinholes in the photosensitive layer after alkaline development and treatment with an acid etching solution, for example an acid ceric ion-containing solution for chromium. The second disadvantage is the increase in the number and size of these pinholes which takes place when these photographic materials undergo storage over a period of time before processing. This ageing process makes the exposed photographic materials unusable as photoresists after a certain storage time, or even immediately after their production when particularly high standards are placed on the photoresists, as for example in the production of microelectronic printed circuits. Bearing in mind the characteristic advantages of a photographic system of the aforementioned type, it will therefore be appreciated how the overcoming of the aforementioned disadvantages would yield a product capable of wide application in photolithographic processes.

It is an object of this invention to produce a photographic material or photographic system of the aforementioned type, the photographic material comprising a photosensitive substance and the photographic system comprising an alkaline developer to be used thereon after imagewise exposure, which shows good photo-selectivity of dissolution after exposure to radiation.

It is a further object of the invention to provide methods for the production of such photographic

systems and photographic materials for use therein which lead to the productioin of a photographic material which is stable on storage and which because of the photoselectivity of dissolution on development will provide high photographic sensitivity, thereby enabling use of the developed photographic material for photolithographic purposes.

According to the present invention, there is provided a photographic material for use in photolithography, which material is capable of yielding, on imagewise exposure to radiation, a latent positive image, which material comprises a carrier base and on the carrier base, optionally with interposition therebetween and the carrier base of an intermediate layer having adhesive and/or insulating and/or hydrophilic properties, a thin homogenous vapour deposited or heterogeneous photosensitive layer comprising at least one photosensitive substance selected from chalcogenides of phosphorous, arsenic, germanium and metals belonging to Groups Ib, IIb, IIIa, IVa and Va of the Periodic System of the Elements, which photosensitive substance is capable upon exposure to radiation of exhibiting photoselective capacity for dissolution in an alkaline developer which is an aqueous solution of an alkaline developing agent, the photographic material being optionally in association with a said alkaline developer for use on the photographic material after exposure to radiation, thereby forming a photographic system, characterised in that the photographic system, characterised in that the photographic material or the alkaline developer when in association therewith in a said system, contains at least one organic compound selected from dyestuffs having the capacity for dyeing tannined cotton, dyestuffs having the capacity for dyeing synthetic fibres, compounds capable of acting as accelerators, antioxidants or age resistors in the vulcanization of elastomers and developing agents effective in the development of silver halide-based photographic materials.

The carrie base of a photographic material, either embodying the invention or used in association with an alkaline developer in a photographic system embodying the invention, can be of any one of a wide variety of materials, for example, plastics, paper, cardboard, glass, ceramic material or metal. The size, shape and contours of the surface of the carrier base to which the photosensitive layer is to be applied can be selected in accordance with the intended use of the photographic material to be produced. In some cases, it may be necessary for there to be between the carrier base and the photosensitive layer, an intermediate layer which does not react with the photosensitive layer when the latter is exposed to radiation and which is formed, for example, of rubber, lacquer, plastics, metal, for example chromium or aluminium, dielectric materials used in the production of thin films for optical purposes etc., or a combination of several such layers applied in turn. Depending on the properties thereof, the intermediate layer or layers serve to improve the adhesion of the photosensitive layer to the carrier base and/or the isolation of the photosensitive layer from the carrier base when the latter might otherwise react with the photosensitive substance during exposure and/or to render the carrier base hydrophilic as for example when it is to be used in the production of offset printing formes. The provision of metal intermediate layers will be of particular value when preparing photoresist materials.

The photosensitive layer comprises an inorganic photosensitive substance which, after exposure to radiation, undergoes photoselective dissolution on treatment with an alkaline developer. Such inorganic photosensitive substances may be deposited pure or doped with halogen and will be sulphides, selenides and tellurides of one or more elements selected from phosphorous, arsenic, germanium and certain metals, being metals belonging to groups Ib, IIb, IIIa, IVa and Va of the Periodic Table of the elements, being especially antimony (III), cadmium and bismuth, as in for example antimonous, cadmium and bismuth sulphides. Another preferred material is phosphorous sulphide. The photosensitive materials are preferably amorphous substances, for example arsenous sulphides and mixtures of a number of the aforementioned elements, in particular arsenic, sulphur, germanium and selenium. From the foregoing, it will be appreciated that the photosensitive substances are not ncessarily simple compounds but may contain the respective elements in other than an exact stoichiometric ratio.

The development of the photographic material in discrete areas to obtain a latent positive image is carried out using an alkaline developer, that is an aqueous alkaline solution. For this purpose it is possible to employ, for example, salts of strong bases and weak acids, for example lithium, sodium, potassium and ammonium carbonates, phosphates, sulphides, polyphosphates or borates, hydroxide solutions, for example alkaline metal hyroxides and aqueous ammonia, solutions of organic compounds which undergo alkaline reaction, for example aliphatic amines, diamines, polyamines, and quaternary phosphonium oxides.

Both the inorganic photosensitive substance and the alkaline developing agent may contain mixtures of substances as aforementioned.

The organic compounds employed according to the present invention in the photographic material itself or in the developing agent for use therewith in order to improve the properties and photographic characteristics of the photographic material after processing may be selected from three fundamental classes of materials.

Thus, it is possible to employ an organic dyestuff which may be a dyestuff suitable for use in the dyeing of tannined cotton. Examples of dyestuffs which may be used for this purpose and in the aforementioned photographic materials are xanthine, acridine, azine, oxazine, thiazine, diphenylmethane, triphenylmethane, cyanine and basic azodyes. It is also possible to employ dyestuffs suitable for use in the dyeing of synthetic fibres, especially polyacrylonitrile and acrylic fibres in general. Dyestuffs of such type

are the commercially available dyes known as Basacryl, Sandocryl, Astrazon, Deorlin, Maxilon and Setacyl dyestuffs depending upon the manufacturer thereof. Although each of these dyestuff names is a trade mark, these trade marks have come to be accepted in the art as the common names by which the dyestuffs are known.

A second group of organic compounds which may be employed are those used in the vulcanization of elastomers as accelerators, antioxidants or age resistors. Examples of these compounds are the following:

1. dithiocarbamates and derivatives thereof having e.g. the general formula:

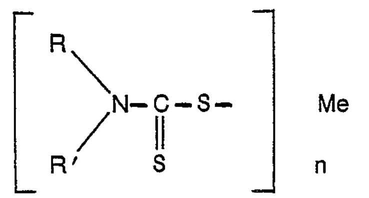

I

wherein R, and R′ are hydrocarbyl radicals, especially alkyl or aryl, Me denoates a metal or amino group and n denotes the valency of the metal or amino group;

2. thiuramsulphides and derivatives thereof e.g. having the general formula:

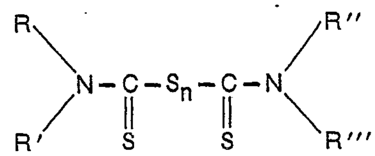

II

wherein R, R′, R″ and R‴ are hydrocarbyl radicals, especially alkyl or aryl and n denotes an integer from 1 to 4;

3. thiazoles and derivatives thereof having e.g. the general formula:

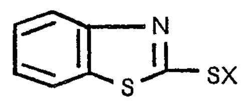

III

wherein X denotes hydrogen, a metal atom or an organic radical;

4. sulphonamides and derivatives thereof having e.g. the general formula

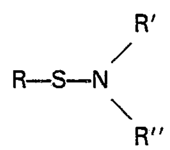

IV

wherein R denotes a thiazolyl or benzthiazolyl radical, or a residue of a carbamic acid or a heterocyclic compound and R′ and R″ denote hydrocarbyl radicals, especially alkyl and or aryl radicals;

5. guanidines having e.g. the general formula:

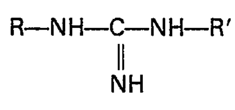

V

wherein R and R′ denote hydrocarbyl radicals especially aryl radicals;

6. aldamines having e.g. the general formula:

R—N=CH—R′

IV

wherein R denotes a hydrocarbyl group, especially an alkyl or aryl radical and R′—CH = denotes the residue of an aldehyde; and

7. a heterocyclic five-membered ring-containing compound in which the ring contains from 1 to 4 heteroatoms and sulphonated derivatives and sulphydryl (mercapto) derivatives thereof.

The antiageing action is also achieved with those organic compounds effective in the development of silver halide-based photographic materials, for example N-methyl-p-aminophenol sulphate, for example (metol), hydroquinone, 2,4-diaminophenol dihydrochloride (amidol), pyrocatechol, para-aminophenol and para-phenylenediamine.

In production the aforementioned photographic materials, the photosensitive layer is generally deposited in a thickness of from 0.01-10 μm on the carrier base by any of the methods known for this purpose, for example, evaporation of sputtering in a vacuum of the inorganic photosensitive substance or substances.

It is possible to carry out the simultaneous evaporation of one or more pre-prepared compounds and/or of the individual elements thereof which combine on the substrate. As an alternative to employing such a method, it is also possible to deposit the photosensitive layer by centrifugation of a powder compaction or by spreading thereover a solution or suspension of one or more inorganic photosensitive substances in a suitable liquid medium, for example, water, followed subsequently by drying of the liquid film. A colloidal solution utilised for the last identified purpose can additionally contain a high molecular compound, for example gelatin, plyvinylalcohol or polyvinylpyrrolidone, which after drying of the coated liquid layer forms a photographic emulsion.

The organic compounds used according to the present invention may be introduced into the whole or part of the volume of the photosensitive layer in an overall concentration of from 0.1 to 20% by weight. Alternatively, the photosensitive compound may be applied in several stages separated by the application to the then applied photosensitive layer of the organic compounds. The organic compounds may also be applied to the surface of the photosensitive layer. Organic compounds applied in such a manner as discrete layers thereof may be applied in monomolecular coatings in an amountr of up to $10^{-2}$ g/cm$^2$. As an alternative to incorporating the organic compounds in the photographic material, especially when they are dyestuffs as aforementioned, they can be utilized in addition to or as an alternative to use in the photographic material in the alkaline developing agent in concentrations of from $10^{-2}$ g/l up to the maximum quantity soluble at the working temperature of the developer. When the organic dyestuff is applied as a surface layer on the photosensitive material, such application may take place before or after exposure of the photographic material. The other aforementioned organic compounds utilized according to the present invention will generallly be provided in the photographic material only during preparation of the photosensitive layer. It will therefore be appreciated that different organic compounds as aforesaid may be incorporated in the photographic material either simultaneously or through the aforementioned variants in the doping, use of intermediate films or use of surface films on the photosensitive layer contemplated in the foregoing.

The introduction of the organic compound or combinations thereof in the whole or part of the volume of the finished photosensitive layer can be achieved by evaporation thereof in vacuum and condensation of vapours thereof together with the vapours of the inorganic photosensitive substance. Such organic compounds can also be deposited at a time when deposition of the inorganic photosensitive substance is not taking place as one or more intermediate films at different depths in the photosensitive layer and/or on its surface. Deposition of the organic compounds on the surface of the photosensitive layer or as an intermediate film can also be achieved by dipping the then produced photographic material in a solution of the relevant organic compound for from 10-300 seconds or by applying the organic compound to the surface of the photographic material from a solution thereof by centrifugation, powdering, or by spreading or coating of solution of the organic compound and subsequently drying the photographic material.

When the organic compound is coated onto the photographic material in the form of a solution or suspension, the organic compound may be aded to the solution or suspension prior to application thereof to the carrier base.

The aforementioned dyestuffs, in particular, may be applied to the photographic material from the alkaline developing agent only at the time of developing the latent positive image produced on the photographic material. The organic dyestuffs may be added directly to the alkaline developing agent or in the form of a solution in a solvent, for example water, or an organic solvent, for example an alcohol, ketone, ester or mixtures thereof miscible with the alkaline developing agent. The type and quantity of the solvent present in the alkaline developing agent influences strongly the efficiency of the dyestuffs. This influence is also observable when the dyestuffs are incorporated into the photosensitive layer. Thus, the addition of alcohols, ketones or esters, or mixtures thereof, to the alkaline developing agent may also be effected when working with water soluble dyestuffs or when they have been introduced previously into the photosensitive layer in order to influence the efficiency of the dyestuffs.

In preparing a photographic system embodying this invention, whether an organic compound according to this invention is incorporated in the photographic material or in the alkaline developing agent, the preparation and optimization of the photographic system from the point of view of quality and photographic characteristics will depend on the type of substrate used, the composition of the photosensitive layer and the manner of its preparation, the nature and quantity of the organic compound or compounds added, the pH of the alkaline developer, the type and quantity of the organic solvent incorporated therein and the type and concentration of the alkaline substance present in the developing agent.

A photographic system embodying this invention has been found to possess the following characteristic advantages:

1. Higher photographic sensitivity which is from 10 to 20 times higher than the sensitivity of hitherto described photographic materials for use in photolithography comprising photosensitive inorganic substances; the photographic sensitivity is of the order of the sensitivity of the organic photolacquers hitherto widely used in photolithographic practice;

2. Non-critical alkaline development permitting variations by from 20-25%, in some cases up to 50%, in development time without leading to inadmissible changes of detail on the image produced on the photographic material, thus enabling accurate reproduction of a subject over the whole area of the photographic material;

3. A shelf life more than six months after the preparation of the photographic material.

In addition to these advantages, the photographic materials possess the characteristic advantages of the inorganic photosensitive systems of the type referred to herein, compared to the organic photolacquers hitherto widely used in photolithographic practice;

4. Exceptionally high resolving power; the possibility of achieving deposition of the photosensitive layer by evaporation or sputtering in a vaccum, thereby achieving excellent uniformity and enabling preparation to be carried out under very clean conditions and in which entry of impurities into the product is substantially avoided;

5. Very good ahesion to the carrier base allowing the etching of the substrate or of an intermediate layer to be carried out safely; multilayer materials containing photosensitive and other inorganic substances may be employed; easy removal of the photosensitive layer, both in respect of exposed and unexposed areas;

6. Sensitivity to exposure with a wide variety of radiation sources including, as well as actinic light, electron beams.

The following non-limiting Examples illustrate the invention:

## Example 1

A film of chromium having an optical density of more than 2 was deposited under a vacuum better than $1.33 \times 10^{-10}$ Pa onto a polished and washed glass substrate. Utilizing the same vacuum conditions, a photosensitive layer 0·1 μm thick was deposited on the chromium film by evaporation of arsenous sulphide from a boat or crucible at a condensation rate of 0.1 nm/s. At the same time as the arsenous sulphide was deposited, telluric diethyl dithiocarbamate was deposited in a concentration of 1.5% in the photosensive layer as a result of its simultaneous evaporation from a second source.

The photographic material thus produced was then exposed to white light through an emulsion or chromium photomask, the plate was dipped for 30 seconds in a saturated aqueous solution of rhodamine B (basic violet 10 — C.I. 45170). Following washing of the plate with deionized water, development of the photosensitive layer was carried out for 3 to 4 minutes in an aqueous alkaline solution having a pH of 11.0 and containing 50 gram per litre sodium carbonate and 50 gram per litre sodium phosphate acidified with phosphoric acid to the aforementioned pH value. The plate was washed under running deionized water and then immersed for 30 to 60 seconds in a solution made up by adding 100 grams ceric ammonium nitrate and 43.2 ml perchloric acid to 1 litre water in order to achieve chromium etching. The plate was then washed thoroughly in deionized water and undissolved photosensitive mateiral was removed by immersion for 5-10 seconds in a 5-10% by weight aqueous solution of sodium hydroxide. The chromium image then produced was washed thoroughly in water and dried.

## Example 2

The produce of Example 1 was repeated in a series of experiments in which the following features of Example 1 were varied;

(a) The organic compound, telluric diethyl dithiocarbamate used in Example 1 was replaced in turn in series of experiments by each of compounds 2 to 13 identified in Table 1 which follows;

(b) Samples produced using each of organic compounds 1 to 16 of Table 1 were each subjected to the following alternative forms of radiation; monochromatic light and electron beams using both emulsion and chromium photomasks;

(c) The procedures of repeat experiments (a) and (b) and also of Example 1 were repeated so that each of dyestuffs 1 to 16 of Table 2 which follows was used in combination with each organic compound of Table 1 and each of the masks and light sources. In each case the aqueous alkaline solution employed with the respective dye had the pH value given in column 5 of Table 2.

(d) In further repeat experiments, the solution of the dye was applied to the paltes by the following methods; powder coating, centrifugation, spreading or coating.

## Examples 3 to 10

The procedure of the foregoing Examples 1 and 2 was repeated in a series of experiments in which in place of the arsenous sulphide as inorganic photosensitive substance, there were used in the respective series of experiments one of the inorganic photosensitive substances set out in Table 3 which follows, applied by evaporation to the carrier base. After exposure, the photosensitive materials were immersed for

30 seconds in a saturated solution of the chosen dye. The alkaline developer employed subsequently is indentified in Table 3 for each of the various inorganic photosensitive substances. After alkaline development, a chromium image was produced in each case by the procedure described in Example 1.

Example 11

The various experiments described in Examples 1 to 10 were repeated but with the difference that, instead of dipping the photographic material in the solution of a dyestuff after exposure, dipping took place in a saturated aqueous solution of the dye for 30 seconds prior to exposure.

After washing and drying, the chromium plate was exposed and developed in accordance with the type of inorganic photosensitive substance used in a developer solution having a pH corrected to the corresponding value in Table 2 or, when the photosensitive substance was a substance identified in Table 3, having the corresponding composition set out in Table 3. In a subsequent stage, the chromium was etched out and the remaining photosensitive layer removed in the manner described in Example 1.

TABLE 1

| No. | Organic compound | Structural formula | Doping concentration weight % |
|---|---|---|---|
| 1 | Telluric diethyldithiocarbonate | 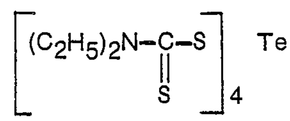 | 1.5 |
| 2 | Tetramethylthiuram-monosulphide | 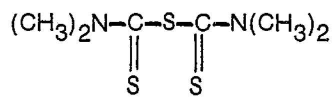 | 0.3 |
| 3 | Altax dibenzothiazole-disulphide | 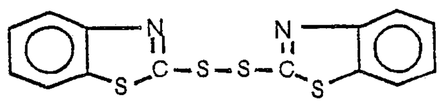 | 0.5 |
| 4 | Vulcacite C | 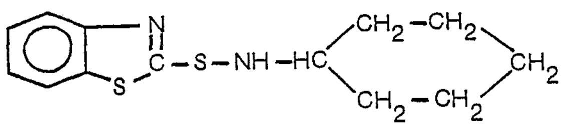 | 0.7 |
| 5 | N,N'-diphenyl-guanidine | 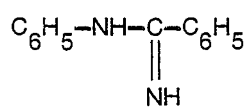 | 1.1 |
| 6 | Accelerant T | | 1.2 |
| 7 | Mercaptobenz-imidazole | 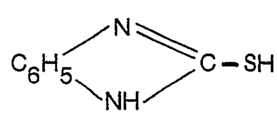 | 1.0 |
| 8 | Phenylmercapto-tetrazole | 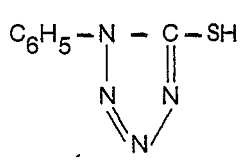 | 1.0 |

TABLE 1 (Continued)

| No. | Organic compound | Structural formula | Doping concentration weight % |
|---|---|---|---|
| 9 | Metol | 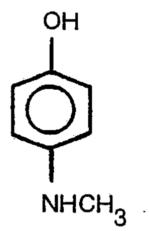 | 0.8 |
| 10 | 1-phenyl-4-amino-5-pyrazolone | 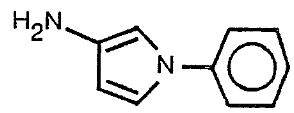 | 0.9 |
| 11 | Ethyleosin | 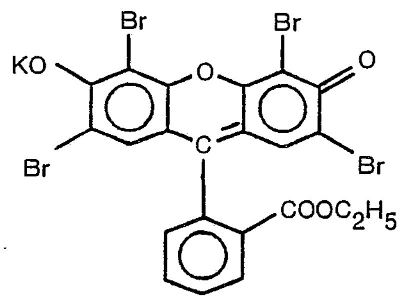 | 1.3 |
| 12 | Alkali blue 6B (C.I. 42765 Acid Blue 119) | 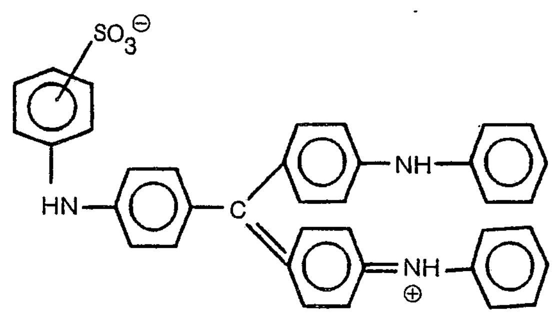 | 1.3 |
| 13 | Rosaniline chloride | 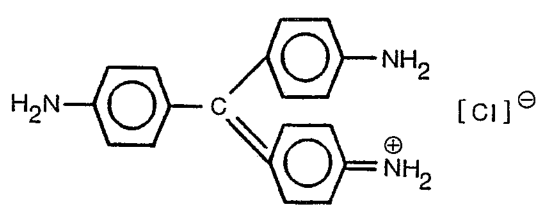 | 1.0 |
| 14 | Chrysoidine (C.I. 11270 Basic Orange 2) | 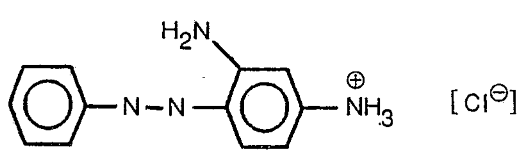 | 0.9 |
| 15 | Luxol brilliant green BL | Relative dye with unknown structure; believed to be a derivative of the triphenylmethane dyes | 1.2 |
| 16 | p-Ethoxy-chrysoidine | 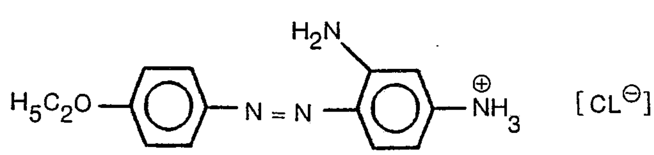 | 1.0 |

TABLE 2

| No. | Name of dye | Structural formula | C.I. | pH of the alkaline devel. solution |
|---|---|---|---|---|
| 1 | Rhodamine B (Basic Violet 10) | 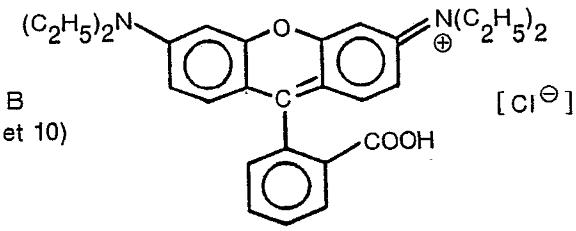 | 45170 | 11.0 |
| 2 | Leather yellow HG (Basic Yellow 9) | 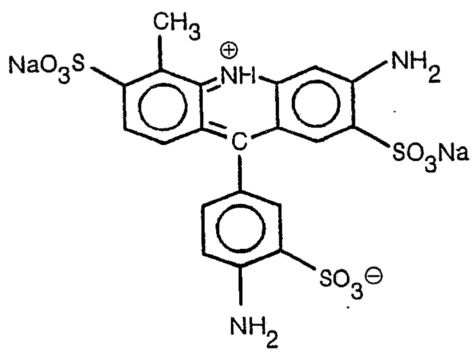 | 46040 | 11.0 |
| 3 | Neutral red (Basic Red 5) | 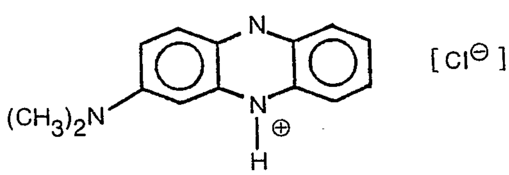 | 50040 | 10.5 |
| 4 | Nile blue (Basic Blue 12) | 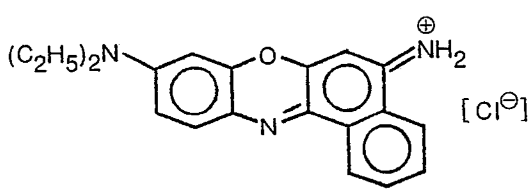 | 51185 | 11.5 |
| 5 | Azur A (Basic Blue 5) | 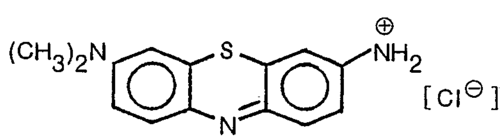 | 42140 | 11.0 |
| 6 | Auramine (Basic Yellow 2) | 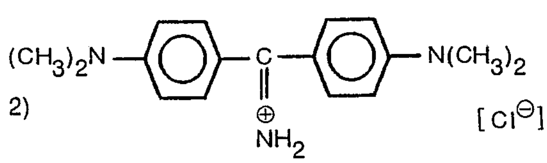 | 41000 | 11.0 |

TABLE 2 (Continued)

| No. | Name of dye | Structural formula | C.I. | pH of the alkaline devel. solution |
|---|---|---|---|---|
| 7 | Soluble blue 6B (Acid Blue 93) | 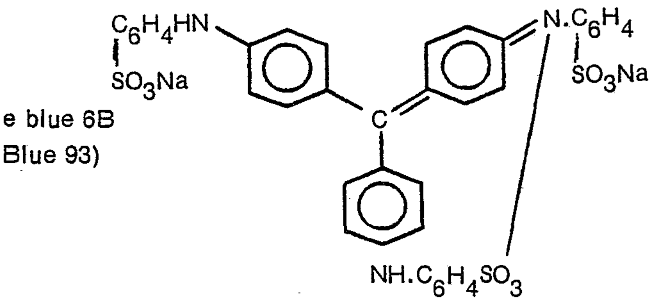 | 42780 | 10.5 |
| 8 | Bismarck brown 6B (Basic Brown 4) | 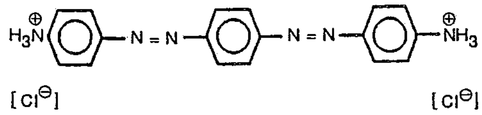 | 21010 | 11.0 |
| 9 | Flavaniline (Basic Dye) | 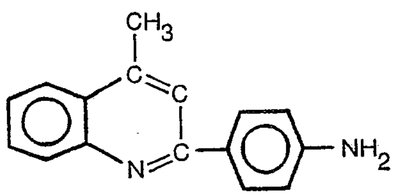 | 47025* | 11.0 |
| 10 | Procion brilliant blue M5BS | 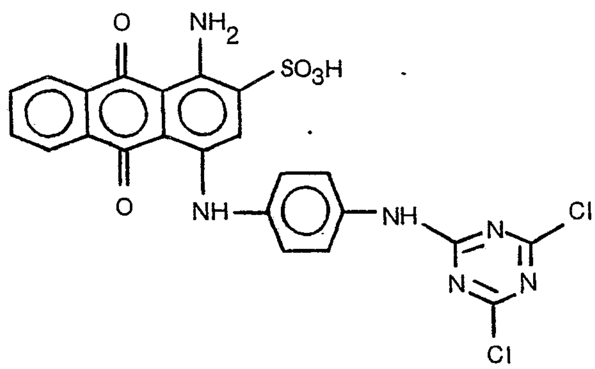 | | 10.5 |
| 11 | Basacryl red XBL (Basic Red 29) | Cationic basic dye of BASF – BRD | S163 | 11.0 |
| 12 | Sandocryl gold yellow BRLE | Cationic dye of Sandoz – Switzerland | | 11.5 |
| 13 | Remacryl orange RRL | Cationic dye of Hoechst, BRD | | 11.0 |
| 14 | Astrazon red RL | Cationic dye of FBy – BRD | | 11.0 |
| 15 | Deorlin light blue R1 | Cationic dye of CIBA – Switzerland | | 11.5 |
| 16 | Maxilon blue 5G | Cationic dye of CIBA – Switzerland | | 11.5 |

* C.I. – Society of Dyers and Colourists, British Colour Index, Rowe F. M. (ed.), 2nd Ed., Bradford, 1956. Suppl. 1963.

Table 3

| No. | Inorganic photosensitive substance | Composition of the alkaline developer |
|---|---|---|
| 1. | $As_{10}Se_{67\cdot5}Ge_{22\cdot5}$ | 0·33N NaOH |
| 2. | $As_2S_5$ | 50 g/l $Na_2CO_3$ |
| 3. | $As_{30}Se_{52\cdot2}Ge_{17\cdot5}$ | 0.33N NaOH |
| 4. | $As_{40}Se_{15}S_{35}Ge_{10}$ | 0.33N NaOH |
| 5. | $Se_{75}Ge_{25}$ | 25% solution of $(CH_3)_2NH$ |
| 6. | $Se_{55}Te_{20}Ge_{25}$ | 25% solution of $(CH_3)_2NH$ |
| 7. | $Se_{69}Sn_{15}Ge_{25}$ | 25% solution of $(CH_3)_2NH$ |
| 8. | $Ge_{17}As_{26}S_{57}$ | 50 g/l $Na_3PO_4$ corrected with $H_3PO_4$ to pH 11.0 |

Example 12

Chromium with an optical density of more than 2 was deposited under vacuum conditions better than $1.33 \times 10^{-3}$ Pa onto a suitably polished washed glass substrate. In the same vacuum cycle, a photosensitive layer 0.1 µm thick was deposited at a condensation rate of 0.1 nm/s onto the chromium whose deposition had been concluded. After depositing the first 0.04 µm of photosensitive layer, without interrupting the evaporation of the arsenous sulphide, simultaneous evaporation of phenylmercaptotetrazole was commenced to achieve simultaneous deposition thereof to dope the next 0.08 µm of photosensitive layer with 1% by weight of phenylmercaptotetrazole. Deposition of arsenous sulphide and phenylmercaptotetrazole was stopped and using the same vacuum conditions, Eosin (C.I. 45380 — Acid Red 87) was deposited on the surface of the phootosensitive layer in an amount of $3.5 \times 10.^{-4}$ g/cm$^2$.

The thus obtained sensitized chromium plate was exposed and developed in the manner described in Example 1 with the developing solution being corrected intially to a pH of 12.0. After that, the final chromium image was produced by carrying out the post-development stages of Example 1.

Example 13 and comparative Example A

The procedure of Example 12 was repeated but with the following differences:

A. In Example 13, Eosin (CI 45380 Acid Red 87) was not evaporated onto the surface of the sensitized chromium plate; and

B. In comparative Example A, the photosensitive layer was not doped with phenylmercaptotetrazole and Eosin (C.I. 45380 — Acid Red 87) was not evaporated on the surface of the sensitized chromium plate.

Each of the test samples was contact exposed through a chromium mask and subsequently treated in the manner described in Example 1. Comparison data in respect of the products obtained in Comparative Example A, Example 13 and Example 12 are set out in turn in Table 4 which follows. The Table indicates the different pH values of developing solution which were employed. The sensitivity is determined as the reciprocal of the value of the time of exposure at constant intensity of the light source. The data for sensitivity in the sixth column are relative, being based upon the sensitivity of pure arsenous sulphide being equal to 1.

TABLE 4

| No. | Photosensitive layer | pH of the alkaline developer | time of development (s) | Tolerances in development time in % | Relative Sensitivity | Shelf-life months |
|---|---|---|---|---|---|---|
| 1. | $A_2S_3$ | 10.5 | 60 | ± 8 | 1 | ½-1 |
| 2. | $As_2S_3$ doped with phenylmercaptotetrazole | 10.5 | 60 | ±8 | 1 | over 6 |
| 3. | $As_2S_3$ doped with phenylmercaptotetrazole and Eosin on the surface | 12.0 | 330 | ± 25 | 20 | over 6 |

Example 14

Chromium with an optical density above 2 was deposited onto a polished and washed glass substrate under a vacuum better than 1.33 × $10^{-3}$ Pa. Using the same vacuum cycle, 0.1µm thick photosensitive layer was deposited as follows:

Arsenous sulphide was evaporated from a suitable crucible and deposited at a condensation rate of 0.1 nm/s. Simultaneously, Thiuram D, Mercazine I and hydroquinone previously mixed together in equal quantities and pressed into a pellet were evaporated from another crucible so that the photosensitive layer was doped throughout with these materials in an amount of 0.5 % by weight. The chromium photographic plates thus produced were exposed in the manner described in Example 1 or Example 2. Development was then carried out for three to four minutes in an aqueous solution containing 10 g/l sodium hydroxide (acidified with concentrated nitric acid to pH 11.0) and 2 g/l Nile blue (C.I. 51185 — Basic Blue 12). The plates were then thoroughly washed in water, the chromium was etched and the remaining photosensitive layer was removed in the manner described in Example 1.

Example 15

Chromium photoplates were produced in the manner described in Example 13. They were then exposed in the manner described in Examples 1 and 2 and were developed in a developing agent prepared in the following manner:

15 g potassium hydroxide were added to 900 ml water and the pH of the solution was adjusted to 11.0 with concentrated sulphuric acid. 2 g Cryptocyanine were dissolved in 100 ml ethyl alcohol and this alcoholic solution was added to the aqueous developing agent with intensive stirring. Development was carried out for 3 to 4 minutes. The developed photographic plates were then washed thoroughly in water, the chromium was etched and the remaining photosensitive layer was removed in the manner described in Example 1.

Example 16

Chromium photographic plates were prepared in the manner described in Example 14. They were exposed in the manner described in Example 1 and then developed for 3 to 4 minutes in a developing agent having the composition given in Example 1 corrected to pH 11.0 and to which were added 4 g/l Acridine orange (C. I. 46005 — Basic organe 14), 0.5 g/l Safranine O (C.O. 50240 — Basic Red 2), 0.1 g/l Methylene blue (C.I. 52015 — Basic Blue 9) and 2 g/l Erythrosine (C.I. 45430 — Acid Red 51). The operations described in Example 1 were then carried out until the final chromium image was produced.

Example 17

A photosensitive layer of arsenous sulphide vapour deposited under a vacuum better than 1.33 × $10^{-3}$ Pa onto an anodised aluminium offset forme in a thickness of 0.1 µm at a rate of deposition of 1 nm/s. The forme was exposed to a mask on a copying frame and was developed in a solution produced by adding 75 g sodium carbonate, 0.2 g Pyronine Y (C.I. 45005* Basic Dye) to 1 litre water. Development was carried out for about 100 s by wiping the forme with a cotton pad soaked with the developing solution in some experiments and by dipping in a bath or a developing unit in other experiments. The formes were then washed under running water and subjected to hydrophilisation by immersion in an aqueous solution of phosphoric acid in a concentration of 50 ml/l. After a second washing in water, inking and gumming with gum arabic, the forme was ready for printing.

Comparative Example B

The procedure of Example 17 was repeated with formes being produced in the manner described in Example 15 and developed in the same alkaline developing agent before the omission of the Pyronine Y (C.I. 45005* Basic Dye) therefrom. At equal sensitivities, this absence of the dye from the developing agent led to a higher critical response in respect of the time of development (10-15 seconds) as compared with the developing time when Pyronine Y (C.I. 45005* Basic Dye) was present in the alkaline developing agent (70-140 s).

Examples 18 to 23

The procedure of Example 17 was repeated but using in place of the arsenous sulphide in Examples 16 to 21, the inorganic photosensitive substances 1 to 5 respectively. The plates produced were exposed to a mask for a suitable time on a copying frame and developed for 1 to 2 minutes in the manner described in Example 15 but using developing solutions differing from that used in Example 17 in respect of the basic component thereof as indicated in Table 5. The procedure described in Example 15 was continued until a ready offset forme was produced in each case.

TABLE 5

| No. | Inorganic photsensitive substance | Composition of the alkaline developer |
|---|---|---|
| 1. | $P_2Se_3$ | 16% solution of $(CH_3)_2NH$ |
| 2. | $As_3Se_7$ | 4% solution of $(CH_3)_2NH$ |
| 3. | $As_2Se_3$ | 33% solution of $(CH_3)_2NH$ |
| 4. | $P_{20}Se_{60}Ge_{20}$ | 10% solution of $(CH_3)_2NH$ |
| 5. | $As_2Sa_3I_{1\cdot 2}$ | 2.3 g/l of $Na_2CO_3$ |

Example 24

A photosensitive layer was deposited onto an anodised aluminium offset forme by evaporation under a vacuum better than 1.33 $10^{-3}$ Pa in the following manner:

Employing a condensation rate of 1 nm/s, there were deposited in turn a 0.02 μm thick layer of arsenous sulphide followed by a layer of $1 \times 10^{-4}$ g/cm$^2$ of Victoria Blue B (C.I. 44045 — Basic Blue 26). This process was repeated twice with the same quantities of arsenous sulphide and dye being deposited in each step. A final layer of arsenous sulphide 0.025 μm thick was then deposited on the third dyestuff coating. The sensitized offset forme thus produced was exposed to a suitable mask and was developed using a cotton pad soaked in 50 g/l aqueous solution of sodium carbonate. Subsequent working up of the forme was carried out in the manner described in Example 17.

Example 25

The following procedure was adopted to a deposit onto an anodised aluminium offset forme under a vacuum better than $1.33 \times 10^{-3}$ Pa a photosensitive layer:

In turn there were deposited the following — 0.025 μm thick layer of arsenous sulphide, followed by $1 \times 10^{-4}$ g/cm$^2$ of Victoria Blue B (C.I. 44045 — Basic Blue 26) — followed by a further 0.025 μm thick layer of arsenous sulphide to which was then applied a layer of Patent Blue A (C.I. 42052 — Acid BLue 5) in a thickness of $0.8 \times 10^{-4}$ g/cm$^2$ followed next by a further 0.025 μm thick layer of arsenous sulphide and then Cyanosine B deposited in an amount of $1.1 \times 10^{-4}$ g/cm$^2$. Finally arsenous sulphide was deposited in a thickness of 0.025 μm followed by a surface layer containing equal quantities of the three dyes in a mixture produced by simultaneous evaporation from respective sources thereof, the total amount of the dyes in this final layer being $0.1 \times 10^{-4}$ g/cm$^2$.

The sensitized offset forme thus produced was exposed and developed by the procedure of Example 17 using a 50 g/l aqueous solution of sodium carbonate developing agent. Subsequent working up was by the procedure described in Example 17.

Example 26

A photosensitive layer was vacuum deposited onto an anodised aluminium offset forme under a vacuum better than $1.33 \times 10^{-3}$ Pa in the following way:

Arsenous sulphide was evaporated from a crucible so as to be deposited in an amount 1 nm/s. Simultaneously, diphenyl guanidine was evaporated from another crucible, doping the arsenous sulphide to an extent of 7.0 weight per cent. After the first 0.03 μm of arsenous sulphide doped with diphenyl guanidine had been deposited, $5 \times 10^{-4}$ g/cm$^2$ of the dyes Luxol brilliant green BL and p-ethoxychrysoidine previously mixed in equal quantities and homogenised were evaporated onto the already deposited sensitized layer. When deposition of these dyes was completed, the two deposition stages were repeated in the same order. Finally there as applied to the second mixed dye layer, 0.04 μm of arsenous sulphide doped with diphenyl guanidine to the aforementioned extent followed by a deposit of $1 \times 10^{-5}$ g/cm$^2$ of p-ethoxychrysoidine evaporated from a fourth source.

The thus sensitized offset forme was exposed and developed in the manner described in Example 17 using a 50 g/l aqueous solution of sodium carbonate. The forme was then worked up in the manner described in Example 17.

Example 27

A photosensitive layer was vacuum deposited under a vacuum better than $1.33 \times 10^{-3}$ Pa onto an anodised aluminium offset forme in the following way:

Arsenous sulphide was evaporated from a crucible and deposited on the forme at a condensation rate

of 1 nm/s while simultaneously Chrysoidine (C.I. 11270 — Basic Orange 2) was evaporated from a second crucible to dope the arsenous sulphide to an extent of 8% by weight.

The thus sensitized offset forme was then exposed and developed in the manner described in Example 17 using a 75 g/l aqueous solution of sodium carbonate. The forme was then worked up in the manner described in Example 17.

Example 28

A photosensitive layer having a thickness of 0.5 µm was vapour deposited under a vacuum better than $1.33 \times 10^{-3}$ Pa onto a polished washed glass substrate by evaporation of arsenous sulphide from a crucible, deposition taking place at a rate of 0.1 nm per second. The deposition of arsenous sulphide was accompanied by the simultaneous deposition of 2,2-dithiobisbenzthiazole (Altax) evaporated from a second source to dope the photosensitive layer to an extent of 0.5% by weight. A layer of Eosin (C.I. 45380 — Acid Red 87) was then vacuum deposited from a third source onto the doped arsenous sulphide layer in an amount of $4 \times 10^{-4}$ g/cm$^2$.

The photographic plates thus produced were exposed by means of a laser having a wavelength of 488 nm and a sinusoidal distribution of light intensity. The plates were developed for 9-10 minutes in the developing agent solution specified in Example 1 whose pH was corrected to 11.0 with phosphoric acid. After washing and drying, a relief diffraction grid was obtained. After additional evaporation of aluminium, a reflective diffraction grid was obtained.

Example 29

A photographic emulsion prepared in the manner described in Bulgarian Authorship Certificate 27331 was applied to a carrier base and exposed in the manner described in Example 28 after which it was developed for 1-2 minutes in the alkaline developing solution used in Example 14. After thoroughly washing the developed emulsion in water to achieve complete removal of the dye and drying the resulting product, a ready phase grid was obtained.

**Claims**

1. A photographic material for use in photolithography, which material is capable of yielding, on imagewise exposure to radiation, a latent positive image, which material comprises a carrier base and on the carrier base, optionally with interposition therebetween and the carrier base of an intermediate layer having adhesive and/or insulating and/or hydrophilic properties, a thin homogenous vapour deposited or heterogeneous photosensitive layer comprising at least one photosensitive substance selected from chalcogenides of phosphorus, arsenic, germanium and metals belonging to Groups Ib, IIb, IIIa, IVa and Va of the Periodic System of the Elements, which photosensitive substance is capable upon exposure to radiation of exhibiting photoselective capacity for dissolution in an alkaline developer which is an aqueous solution of an alkaline developing agent, the photographic material being optionally in association with a said alkaline developer for use on the photographic material after exposure to radiation, thereby forming a photographic system, characterized in that the photographic material or the alkaline developer when in association therewith in a said system, contains at least one organic compound selected from dyestuffs having the capacity for dyeing tannined cotton, dyestuffs having the capacity for dyeing synthetic fibres, compounds capable of acting as accelerators, antioxidants or age resistors in the vulcanization of elastomers and developing agents effective in the development of silver halid-based photographic materials.

2. A photographic material or system as claimed in claim 1, wherein the dyestuff having the capacity for dyeing tannined cotton is a xanthine, acridine, azine, thiazine, diphenylmethane or triphenylmethane dye, a basic azo dye or a cyanine dye.

3. A photographic material or system according to claim 1 or 2, wherein the dyestuff having the capacity for dyeing synthetic fibres is a dyestuff for dyeing polyacrylonitrile or acrylic fibres selected from those known by the trade name Basacryl, Sandoacryl, Remacryl, Astrazon, Deorlin, Maxilon and Setacyl.

4. A photographic material according to any preceding claim, wherein the compound capable of acting as an accelerator, antioxidant or age resistor in the vulcanization of elastomers is selected from dithiocarbamates, thiuramsulphides, thiazoles, sulphonamides, guanidines and aldamines having the general formulae I to IV respectively as follows:

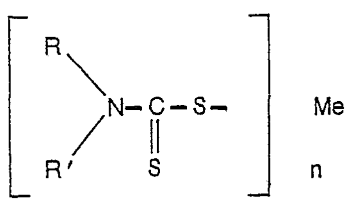

I

wherein R and R′ are hydrocarbyl radicals, Me denotes a metal or amino group and n denotes the valency of the metal or amino group;

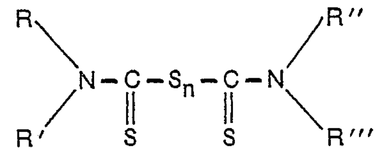

II

wherein R, R′, R″ and R‴ are hydrocarbyl radicals and n denotes an integer of from 1 to 4;

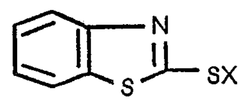

III

wherein X denotes hydrogen, a metal atom or an organic radical;

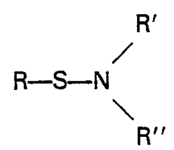

IV

wherein R denotes a thiazolyl or benzthiazolyl radical, or a residue of a carbamic acid or a heterocyclic compound, and R and R″ denotes hydrocarbyl radicals;

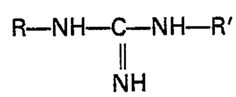

V

wherein R and R′ denote hydrocarbyl radicals; and

R—NH = C—R′ VI

wherein R denotes a hydrocarbyl radical and R′—CH= denotes the residue of an aldehyde; and heterocyclic compounds containing a heterocyclic five-membered ring and sulphonated and sulphydryl derivatives thereof.

5. A photographic material or system as claimed in any one of the preceding claims, wherein the developing agent effective in the development of silver halide-based photographic materials is selected from N-methyl-p-aminophenol sulphate, hydroquinone, 2,4-diaminophenol dihydrochloride, pyrocatechol, para-aminophenol and para-phenylenediamine.

6. A photographic material or system according to any one of the preceding claims, wherein the carrier base or a said intermediate layer is formed of an acid etchable metal on which the photosensitive layer has been deposited, which metal does not react with the photosensitive substance on exposure of the photosensitive layer to radiation.

7. A photographic material or system according to any one of claims 1 to 5, wherein said etchable metal is chromium or is aluminium which has been anodised.

8. A photographic material or system according to any one of the preceding claims, wherein the organic compound(s) is (are) present in the photosensitive layer as a compound or compounds doping the photosensitive layer in an overall concentration of 0.1 to 20% by weight through part or all of its thickness and/or constitute(s) one or more intermediate discrete films at different depths within the layer of photosensitive layer and/or is deposited on the surface of the photosensitive layer in an amount varying from a mono-atomic film up to an amount of $10^{-2}$ g/cm$^2$.

9. A photographic material according to claim 8 which is an exposed photographic material in which the organic compound(s) has (have) been introduced into the photosensitive layer or applied to its surface after exposure of the photographic material.

10. A photographic material according to claim 8, which is an unexposed photographic material in which the organic compound(s) has (have) been incorporated in the photosensitive layer and/or applied to its surface during the preparation of the layer.

11. A photographic material or system according to any one of the preceding claims, comprising at least one compound capable of acting as an accelerator, antioxidant or age resistor and/or developing agent effective in the development of silver halide-based photographic materials incorporated in the photosensitive layer and/or applied to its surface during the production of the photosensitive layer.

12. A photographic material or system according to any one of the preceding claims, wherein the photosensitive layer is vacuum deposited on the carrier base in a thickness of 0.01 to 10 μm.

13. A photographic material or system according to claim 12, wherein the organic compound(s) has (have) been introduced into the photosensitive layer by simultaneous evaporation of the organic compound(s) and the photosensitive substance and deposition together on the carrier base and/or said compound(s) is (are) deposited as one or more discrete intermediate layers at one or more depths in the photosensitive layer by evaporation and deposition and/or said compound(s) is (are) vacuum deposited on the surface of the photosensitive layer.

14. A photographic material or system according to any one of claims 1 to 11, wherein the inorganic photosensitive substance(s) is (are) applied to the carrier base as a solution or suspension containing one or more said organic compounds which has subseqently been dried.

15. A photographic material or system according to any one of claims 1 to 11, wherein the organic compound(s) is (are) coated on the surface of the photosensitive layer and/or is (are) present in one or more intermediate films produced by immersion of the carrier base in a solution of the organic compound(s) or by depositing a said solution on the carrier base by centrifugation, powder coating, spreading or coating thereof.

16. A photographic system according to any one of the preceding claims 1 to 8 and 11 to 15, wherein the alkaline developer contains one or more said dyestuffs in a concentration ranging from $10^{-2}$ g/l to the saturation concentration at the working temperature of the alkaline developer.

17. A photographic system according to claim 16, wherein the organic compound(s) has (have) been incorporated in the alkaline developer as such or in the form of a solution in water or an organic solvent such as an alcohol, ketone, ester or mixture of such solvents.

**Patentansprüche**

1. Photograpisches Material für die Verwendung in der Photolitographie, das bei bildweiser Belichtung ein latentes positivies Bild zu erzeugen vermag, wobei dieses Material eine Trägerbasis und auf dieser, gegebenenfalls unter Zwischenschaltung einer Zwischenschicht met klebenden und/oder isolierenden und/oder hydrophilen Eigenschaften, eine dünne homogene aufgedampfte oder heterogene lichtempfindliche Schicht aufweist, die zumindest einen lichtempfindlichen Stoff enthält, ausgewählt aus der Gruppe der Chalcogenide von Phosphor, Arsen, Germanium und Metallen der Gruppen Ib, IIv, IIIa, IVa und Va des Periodensystems der Elemente, wobei dieser lichtempfindliche Stoff bei Belichtung photoselektives Vermögen für die Losung in einem alkalischen Entwickler zeigt, der eine wässerige Lösung eines alkalischen Entwicklers ist, das photographische Material gegebenenfalls mit einem alkalischen Entwickler zur Verwendung auf dem photographischen Material nach der Belichtung verbuden ist, wodurch ein photographisches System gebildet wird, dadurch gekennzeichnet, daß das photographische Material oder der alkalische Entwickler, sofern diese in einem System verbunden sind, zumindest eine organische Verbindung enthält, ausgewählt unter Farbstoffen, die tanninbehandelte Baumwolle anzufärben vermogen, Farbstoffen, die Kunstfasern anzufärben vermögen, Beschleunigern, Antioxydantien, alterrungshemmende Mittel bei dur Vulkanisation von Elastomeren und für die Entwicklung von photographischen Materialien auf Silberhalogenidbasis geeigneten Entwicklern.

2. Photographisches Material oder System nach Anspruch 1, dadurch gekennzeichnet, daß der Farbstoff, der tanninbehandelte Baumwolle anzufärben vermag, ein Xanthin-, Acridin-, Azin-, Thiazin-, Diphenylmethan oder Triphenylmethanfarbstoff, ein basischer Azofarbstoff oder ein Cyaninfarbstoff ist.

3. Photographisches Material oder System nach Anspruch 1 oder 2, dadurch gekennzeichnet, daß der Farbstoff, der synthetische Fasern anzufärben vermag, ein Farbstoff zum Anfärben von Polyacrylonitril- oder Acrylfasern ist, ausgewählt unter den bekannten Acrylfasern Basacryl, Sandoacryl, Remacryl, Astrazon, Deorlin, Maxilon und Setacyl.

4. Photographisches Material nach einem der vorhergehenden Ansprüche, dadurch gekennzeichnet, daß die als Beschleuniger, Antioxydans oder alterungshemmendes Mittel bei der Vulkanisation von Elastomeren wirkende Verbindung ausgewählt wird aus der Gruppe der Dithiocarbamate, Thiuramsulfide, Thiazole, Sulfonamide, Guanidine und Aldamine einer der allgemeinen Formel I bis VI

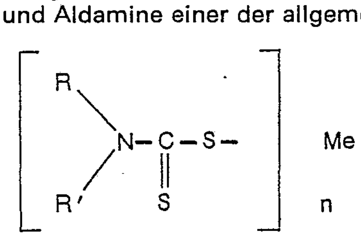

I

worin R und R'Kohlenwasserstoffreste, Me ein Metall oder eine Aminogruppe und n die Wertigkeit des Metalls oder der Aminogruppe bedeuten;

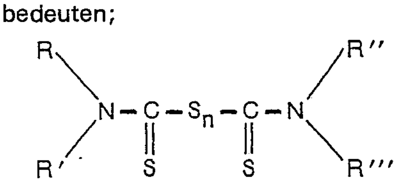

II

worin R, R', R'' und R''' Kohlenwasserstoffreste und n eine ganze Zahl von 1 bis 4 bedeuten;

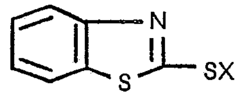

III

worin X Wasserstoff, ein Metallatom oder einen organischen Rest bedeutet;

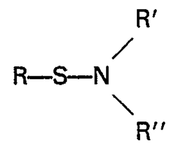

IV

worin R einen Thiazolyl- oder Benzthiazolylrest oder den Rest einer Carbamidsäure oder eine heterocyclische Verbindung, und R und R'' Kohlenwasserstoffreste bedeuten;

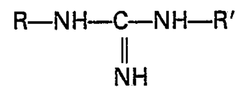

V

worin R und R' Kohlenwasserstoffreste sind; und

R—N=CH—R' VI

worin R einen Kohlenwasserstoffrest und R'—CH= den Rest eines Aldehyds bedeuten; und heterocyclischen Verbindungen mit eiinem heterocyclischen fünfgliedrigen Ring und sulfonierten Derivaten und Sulfhydrylderivaten davon.

5. Photographisches Material oder System nach einem der vorhergehenden Ansprüche, dadurch gekennzeichnet, daß der bei der Entwicklung von photographischen Materialien auf Silberhalogenidbasis wirksame Entwickler ausgewählt wird aus der Gruppe N-Methyl-p-aminophenolsulfat, Hydrochinon, 2,4-Di-aminophenoldihydrochlorid, Brenzkatechin, p-Aminophenol und p-Phenylendiamin.

6. Photographisches Material oder System nach einem der vorhergehenden Ansprüche, dadurch gekennzeichnet, daß die Trägerbasis oder die Zwischenschicht aus einem mit Säure ätzbaren Metall gebildet wird, auf das die lichtempfindliche Schicht aufgebracht worden war, wobei dieses Metall bei Belichtung der lichtempfindlichen Schicht mit der lichtempfindlichen Substanz nicht reagiert.

7. Photographische Material oder System nach einem der Ansprüche 1 bis 5, dadurch gekennzeichnet, daß das ätzbare Metall Chrom oder anodisiertes Aluminium ist.

8. Photographisches Material oder System nach einem der vorhergehenden Ansprüche, dadurch gekennzeichnet, daß die organische Verbindung (en) in der lichtempfindlichen Schicht zur Dotierung dieser Schicht in einer Gesamtkonzentration von 0,1 bis 20 Gew.-% in einem Teil oder der gesamten Dicke der Schicht enthalten ist (sind) und/oder einen oder mehrere diskrete zwischengelagerte Filme in verschiedenen Tiefen der lichtempfindlichen Schicht bildet bzw. bilden und/oder auf die Oberfläche der lichtempfindlichen Schicht in einer Menge aufgebracht ist (sind), die sich zwischen einerm Film aus einer monoatomaren Schicht und einer Menge von 1 bis $10^{-2}$ g/cm$^2$ bewegt.

9. Photographisches Material nach Anspruch 8, dadurch gekennzeichnet, daß es ein belichtetes photographisches Material ist, bei dem die organische (n) Verbindung (en) in die lichtempfindliche Schicht eingearbeitet oder auf ihre Oberfläche nach der Belichtung des photographischen Materials aufgebracht wurde(n).

10. Photographisches Material nach Anspruch 8, dadurch gekennzeichnet, daß es ein nichtbelichtetes photographisches Material ist, bei dem die organische(n) Verbindung(en) in die lichtempfindliche Schicht eingearbeitet und/oder während der Herstellung der Schicht auf ihre Oberfläche aufgebracht wurde(n).

11. Photographisches Material oder System nach einem der vorhergehenden Ansprüche, dadurch gekennzeichnet, daß sie zumindest eine Verbindung enthält, die als Beschleuniger, Antioxydans oder alterungshemmendes Mittel und/oder als bei der Entwicklung von photographischen Materialien auf Silberhalogenidbasis wirksamer Entwickler zu wirken vermag, wobei diese Verbindung in die lichtempfindliche Schicht eingearbeitet und/oder während der Herstellung der Schicht auf ihre Oberfläche aufgebracht wurde.

12. Photographisches Material oder System nach einem der vorhergehenden Ansprüche, dadurch gekennzeichnet, daß die lichtempfindliche Schicht durch Vakuumbedämpfung auf den Träger in einer Dicke von 0,01 bis 10 µm aufgebracht ist.

13. Photographisches Material oder System nach Anspruch 12, dadurch gekennzeichnet, daß die organische(n) Verbindung(en) in die lichtempfindliche Schicht durch gleichzeitiges Verdampfen der organischen Verbindung(en) und der lichtempfindlichen Substanz und gleichzeitiges Abscheiden auf den Träger eingearbeitet wurde(n) und/oder die Verbindung(en) als eine oder mehrere diskrete Zwischenschichten in einer oder mehreren Tiefen in der lichtempfindlichen Schicht durch Verdampfen und

Abscheiden aufgebracht wurde(n) und/oder die Verbindung(en) auf die Oberfläche der lichtempfindlichen Schicht durch Vakuumbedämpfung aufgebracht wurde(n).

14. Photographisches Material oder System nach einem der Ansprüche 1 bis 11, dadurch gekennzeichnet, daß die anorganische(n) lichtempfindliche(n) Substanz(en) auf den Träger als eine oder mehrere organisches Verbindungen enthaltende Lösung oder Suspension aufgebracht wird, die nachfolgend getrocknet wird.

15. Photographisches Material oder System nach einem der Ansprüche 1 bis 11, dadurch gekennzeichnet, daß die organische(n) Verbindung(en) auf die Oberfläche der lichtempfindlichen Schicht aufgebracht wird (werden) und/oder in einer oder mehreren zwischengeschalteten Filmen vorliegt, hergestellt durch Immersion des Trägers in eine Lösung der organischen Verbindung(en) oder durch Abscheiden der Lösung auf den Träger durch Zentrifugieren, Pulverbeschichtung, Auftragen oder Überziehen.

16. Photographisches System nach einem der Ansprüche 1 bis 8 und 11 bis 15, dadurch gekennzeichnet, daß der alkalische Entwickler einen oder mehrere Farbstoffe in einer Konzentration von $10^{-2}$ g/l bis zur Sättigungskonzentration bei der Betriebstemperatur des alkalischen Entwicklers enthält.

17. Photographisches System nach Anspruch 16, dadurch gekennzeichnet, daß die organische(n) Verbindung(en) dem alkalischen Entwickler als solche oder in Form einer Lösung in Wasser oder einem organischen Lösungsmittel wie Alkohol, Keton, Ester oder einem Gemisch dieser Lösungsmittel zugesetzt wurde(n).

**Revendications**

1. Un matériau photographique destiné à la photolithiographie, ledit matériau étant capable de produire, sous exposition en image à des radiations, une image latente positive, ledit matériau comprenant un support de réaction et, sur celui-ci, avec interposition facultative entre ledit matériau et ledit support de réaction d'une couche intermédiaire dotée de propiétés adhésives et/ou isolantes et/ou hydrophiles, une fine couche homogène déposée en phase gazeuse ou hétérogène photosensible, comportant au moins une substance photosensible choisie parmi des chalcogénures de phosphore, d'arsenic, de germanium et de métaux appartenant aux Groupes Ib, IIb, IIIa, IVa et Va du Système Périodique des Eléments, ladite substance photosensible étant susceptible de présenter sous exposition à des radiations une capacité photosélective de dissolution en révélateur alcalin, lequel est constitué d'une solution aqueuse d'un agent révélateur alcalin, et ledit matériau photographique pouvant être facultativement combiné avec ledit révélateur alcalin par application de ce dernier sur le matériau photographique après exposition aux radiations, formant par là un système photographique caractérisé en ce que le matériau photographique ou le révélateur alcalin — lorsqu'il est combiné avec le premier dans ledit système — contient au moins un composé organique choisi parmi des matières colorantes capables de colorer du coton tannisé, parmi des matières colorantes capables de colorer des fibres synthétiques, parmi des composés pouvant agir comme accélérateurs, parmi des antioxydants ou parmi des agents résistant au viellissement dans le processus de vulcanisation d'élastomères, et des agents révélateurs efficaces pour la révélation de matériaux photographiques à base d'halogénure d'argent.

2. Un matériau ou système photographique selon la revendication 1, caractérisé en ce que la matière colorante qui a la capacité de colorer du coton tannisé est un colorant à la xanthine, à l'acridine, à l'azine, à la thiazine, au diphénylméthane ou au triphénylméthane, un colorant azoïque basique ou un colorant à la cyanine.

3. Un matériau ou système photographique selon la revendication 1 ou 2, caractérisé en ce que la matière colorante qui a la capacité de colorer des fibres synthétiques est un colorant destiné à la coloration de fibres de polyacrylonitrile ou acryliques, choisi parmi les matières colorantes connues sous les marques commerciales Basacryl, Sandoacryl, Remacryl, Astrazon, Deorlin, Maxilon et Setacyl.

4. Un matériau ou système photographique selon une quelconque des revendications précédentes, caractérisé en ce qu le composé pouvant agir comme accélérateur, antioxydant ou agent résistant au vieillissement dans le processus de vulcanisation d'élastomères est sélectionné parmi des dithiocarbamates, des thiuramsulphides, des thiazoles, des sulfamides, des guanidines et des aldamines, correspondant respectivement aux formules I à VI suivantes:

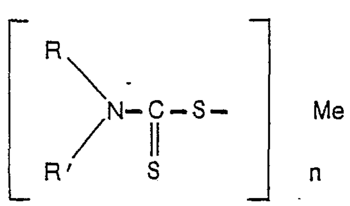
I

où R et R' représentent des radicaux hydrocarboniques, Me un métal ou un amino-groupe et n la valence du métal ou de l'amino-gruppe;

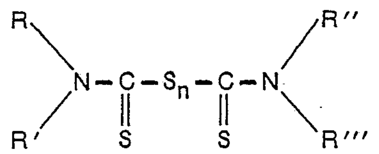

II

où R, R′, R″ et R‴ sont des radicaux hydrocarboniques, et n représente un nombre entier de 1 à 4;

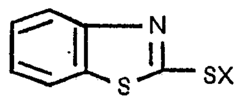

III

où X représente de l'hydrogène, un atome métallique ou un radical organique;

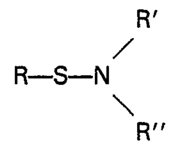

IV

où R représent un radical thioazoïque ou benzothioazoïque ou un résidu d'un acide carbamique ou d'uncompose' hétérocyclique, et R et R″ des radicaux hydrocarboniques;

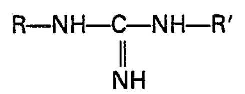

V

où R et R″ représent des radicaux hydrocarboniques; et

$$R—N=CH—R'$$

VI

où R représente un radical hydrocarbonique et R′—CH le résidu d'un aldéhyde; et des composés hétérocycliques contenant une chaîne hétérocyclique de cinq éléments et des dérives sulfonés et sulfhydriques desdits éléments.

5. Un matériau ou système photographique selon une quelconque des revendications précédentes, caractérisé en ce que l'agent révélateur efficace pour la révélation de matériaux photographiques à base d'halogénure d'argent est choisi parmi le sulphate N-méthyl-p-aminophénol, l'hydroquinone, le dihydrochlorure 2,4-diaminophénol, le pyrocatechol, le para-aminophénol et la para-phénylènediamine.

6. Un matériau ou système photographique selon une quelconque des revendications précédentes, caractérisé en ce que le support de réaction ou ladite couche intermédiaire est constitué d'un métal sensible aux acides sur lequel la couche photosensible a été déposée, ledit métal ne réagissant pas avec la substance photosensible lors de l'exposition de la couche photosensible à des radiations.

7. Un matériau ou système photographique selon les revendications 1 à 5, caractérisé en ce que ledit métal sensible aux acides est du chrome ou de l'aluminium anodisé.

8. Un matériau ou système photographique selon une quelconque des revendications précédentes, caractérisé en ce que le(s) composé(s) organique(s) présent(s) dans la couche photosensible dope(nt) cette dernière dans une concentration globale de 0,1 à 20% du poids, sur tout ou partie de son épaisseur et/ou constitue(nt) un ou plusieurs films intermédiaires discrets à différentes profondeurs de la couche photosensible elle-même et/ou est/sont déposé(s) sur la surface de la couche photosensible dans une proportion variant du film monoatomique à $10^{-2}$ g/cm².

9. Un matériau photographique selon la revendication 8, constitué d'un matériau photographique exposé dans lequel le(s) composé(s) organique(s) a/ont été introduit(s) au sein de la couche photosensible ou appliqué(s) sur sa surface après exposition du matériau photographique.

10. Un matériau photographique selon la revendication 8, constitué d'un matériau photographique non exposé dans lequel le(s) composé(s) organique(s) a/ont été introduit(s) au sein de la couche photosensible ou appliqué(s) sur sa surface au cours de la phase de préparation de la couche.

11. Un matériau ou système photographique selon une quelconque des revendications précédentes, caractérisé en ce qu'il comprend au moins un composé pouvant agir comme accélérateur, antioxydant ou agent résistant au vieillissement et/ou agent révélateur efficace pour la révélation de matériaux photographiques à base d'halogénure d'argent, ledit composé étant incorporé dans la couche photosensible et/ou appliqué à sa surface au cours de la phase de production de la couche photosensible.

12. Un matériau ou système photographique selon une quelconque des revendications précédentes, caractérisé en ce que le couche photosensible est déposée sous vide sur le support de réaction, sur une épaisseur de 0,01 à 10 um.

13. Un matériau ou système photographique selon la revendication 12, caractérisé en ce que le(s)

composé(s) organique(s) à/ont été introduit(s) dans la couche photosensible par évaporation simultanée du/des composé(s) organique(s) et de la substance photosensible, et par dépot simultané sur le support de réaction, et/ou caractérisé en ce que le(s)dit(s) composé(s) organique(s) est/sont déposé(s) sous la forme d'une ou de plusieurs couche(s) intermédiaire(s) discrète(s)à une ou plusieurs profondeurs de la couche photosensible par évaporation et dépôt, et/ou le(s)dit(s) composé(s) est/sont déposé sous vide sur la surface de la couche photosensible.

14. Un matériau ou système photographique selon les revendications 1 à 11, caractérisé en ce que la/les substance(s) photosensible(s) inorganique(s) est/sont appliquée(s) sur le support de réactin sous la forme d'une solution ou d'une suspension contenant un ou plusieurs desdits composés organiques séchés en phase ultérieure.

15. Un matériau ou système photographique selon les revendications 1 à 11, caractérisé en ce que le(s) composé(s) organique(s) est/sont enduit(s) surla surface de la couche photosensible et/ou est/sont incoporé(s) en un ou plusieurs film(s) intermédiaire(s) produits par immersion du support de réaction dans une solution du/des composé(s) organique(s) ou par dépôt de ladite solution sur le support de réaction par centrifugation, pulvérisation, étendage ou enduisage.

16. Un système photographique selon une des revendications précédentes 1 à 8 et 11 à 15, caractérisé en ce que le révélateur alcalin contient une ou plusieurs desdites matières colorantes dans une concentration variant de $10^{-2}$ g/l à saturation complète, à la température de service du révélateur alacalin.

17. Un système photographique selon la revendication 16, caractérisé en ce que le(s) composé(s) organique(s) a/ont été incorporé(s) dans le révélateur alcalin tels que ou sous la forme d'une solution aqueuse ou d'une solution de solvant organique telle qu'un alcool, de la cétone, un ester ou un mélane de ces solvants.